# EUROPEAN PATENT APPLICATION

(11) **EP 3 614 422 A1**
(43) Date of publication of application: **26.02.2020**
(21) Application number: 18190223.0
(22) Date of filing: 22.08.2018
(51) Int. Cl.: H01L 21/67, H01L 21/683, C09J 7/35, C09J 7/22, H01L 21/687

(54) **ELECTROSTATIC HOLDING DEVICE**

(71) Applicant: Meyer Burger AG, 3645 GWATT (Thun) (CH)
(72) Inventor: BLASZCZAK, Wlodzimierz, 3661 Uetendorf (CH); MESSERLI, Beat, 3600 Thun (CH); BURRI, Martin, 3123 Belp (CH)
(74) Representative: Patentbüro Paul Rosenich AG

(57) **Abstract**

The invention relates to an electrostatic holding device (10) for electrostatically holding an object, preferably a flat object, such a wafer, a solar cell and/or a foil, comprising
- a receiving surface (4, 4') for receiving an object and
- a support layer (7),
wherein the electrostatic holding device (10) has between the support layer (7) and the receiving surface (4, 4') a layered structure (9) comprising:
- a first electrically insulating layer (1) made of a dielectric film,
- an electrode layer (3) and
- a second electrically insulating layer (2) made of a dielectric film,
wherein the electrode layer (3) is arranged between the first electrically insulating layer (1) and the second electrically insulating layer (2), characterized in that the electrode layer (3) is formed by a film which is built up from a dielectric component (14) and an electrically conductive component (15).

## Description

The invention relates to an electrostatic holding device for electrostatically holding an object, preferably a flat object, such as a wafer, a solar cell and/or a foil, according to the preamble of claim 1.

US 7133273 B2 discloses an electrostatic device for holding a wafer. The U-shaped copper electrode of the electrostatic device is confined between two sheets of insulating material, particularly Kapton (trademark) or any other dielectric material.

Such electrostatic devices are not suitable in the field of wafers, solar cells and wire foils (to be joined with the solar cells), since for such applications a heater for heating the cell and/or a foil is required. Due to the high temperatures and large temperature gradients the stability of such a device is very poor. The risk of damages such as warpage, deformation and ruptures, particularly in the sheets of the insulating material confining the electrode, only after few temperature cycles is very high. Such damages - already at their beginning when they are still masked - have negative impact on the gripping and holding of objects.

It is therefore an object of the invention to provide an electrostatic holding device which overcomes the problems of prior art and which hast high thermal and mechanical stability over multiple heating cycles. The electrostatic holding device should be capable of reliably grip and hold a flat or wafer-shaped object. The construction should be simple and cost-effective. Moreover, the electrostatic holding device should have a long life-time.

The object is achieved by an electrostatic holding device as mentioned at the beginning, wherein the electrode layer is formed by a film which is built up from a dielectric component and an electrically conductive component.

Due to the fact, that the electrode layer is a film which comprises not only an electrically conductive component but also a dielectric component, the mechanical and thermal properties of the electrode layer better matches with those of the first and second electrically insulating layer (each made of a dielectric film). Particularly, the thermal expansion of the electrode layer may be adjusted closer to the thermal expansion of the first and second electrically insulating layer. As a result mechanical stress between the layers is efficiently reduced.

The electrically conducting component of the electrode layer provides the functionality of an electrode as such. The electrically conducting component of the electrode layer is connectable via an electrical connection with an electrical potential for charging the electrically conducting component of the electrode layer (and thus inducing an electrostatic force to the object).

Preferably, the electrode layer is a two layered polyimide film with an electrically conductive layer on one side and a dielectric insulator on the other side. Such a film may be e.g. purchased under the name DuPont™ Kapton® 200RS100. By using polyimide films, such as Kapton®, the thermal stability may be extended up to 240°C. Moreover, the high thermal conductivity of the dielectric polyimide films are of advantage, since the heat has to be transferred to the object, which is preferably a flat object (solar cell or foil). Finally, the disruptive discharge voltage of such a material is very high.

The dielectric component and the electrically conductive component building up the film are integrally connected or coupled with each other.

In a preferred embodiment the thickness of the first electrically insulating layer is smaller than 200µm, preferably smaller than 150µm, more preferred smaller than 100µm.

In a preferred embodiment the thickness of the second electrically insulating layer is smaller than 200µm, preferably smaller than 150µm, more preferred smaller than 100µm .

In a preferred embodiment the thickness of the electrode layer is smaller than 200µm, preferably smaller than 150µm, more preferred smaller than 100µm.

Preferably, the thickness of the film forming the electrode layer amounts between 20µm and 100µm , preferably between 30µm and 70µm, such as 50µm.

Preferably, the electrically conductive component is used as a heater for heating the object (when held by the holding device, i.e. when abutting against the receiving surface of the holding device). For this purpose the electrode layer may be connected to a preferably controllable power source such that a heating current may be lead through the electrode layer (preferably from one side to the opposing side of the electrode layer). The power source may be provided additionally to the above mentioned electrical potential for charging the electrode. The electrode layer, namely its electrically conductive component, then has two functions: inducing an electrostatic force and heating the (flat) object.

In the holding state - i.e. when the electrostatic force attracts the (flat) object - the object abuts against (or touches) the receiving surface of the electrostatic holding device. It is preferred if the receiving surface is at least partially flat in order to match with a flat surface of the object.

In a preferred embodiment the film forming the electrode layer has two sublayers joined with each other, wherein one of the sublayers is formed by the dielectric component and the other sublayer is formed by the electrically conductive component. Here, the electrode layer has two sublayers: an electrically insulating layer, preferably formed from polyimide, and an electrically conductive layer, preferably formed by metal. These two sublayers are fixedly connected with each other; with other words they form integrally a single film.

In a preferred embodiment the dielectric component is an electrically insulating film substrate, which is coated by the electrically conductive component.

In a preferred embodiment the coating formed from the electrically conductive component faces towards the receiving surface, whereas the insulating film substrate formed from the dielectric component faces towards the support layer.

In a preferred embodiment the electrically conductive component is dispersed within the dielectric component. The conductive component may be provided as particles with are distributed within the dielectric component, which forms a matrix for the particles. Here, an optimal combination of the mechanical and thermal properties of the dielectric matrix, preferably formed from polyimide, and the electric conductivity induced by the particles may be achieved.

In a preferred embodiment the dielectric film of the first electrically insulating layer and the dielectric film of the second electrically insulating layer are polyimide films, preferably Kapton. Polyimide films are advantageous due to their mechanical and thermal properties (high temperature resistance up to 240°C or more), particularly for electrostatic holding devices with integrated heating function.

In a preferred embodiment the dielectric component of the film forming the electrode layer is made of polyimide, preferably Kapton. In the case the first and second insulating layers are formed from the same or similar material, the thermal expansion of all layers forming the layered structure, essentially matches with each other. Mechanical stresses due to temperature cycles and gradients may be significantly reduced.

In a preferred embodiment the dielectric component of the film forming the electrode layer is made of the same material as the dielectric film of the first electrically insulating layer and/or the dielectric film of the second electrically insulating layer.

In a preferred embodiment the support layer is formed by a metal plate, preferably an aluminum plate. The support layer forms a rigid basis for the layered structure and - in the case a heater is provided on one side of the support layer - efficiently transfers the heat towards the layered structure.

In a preferred embodiment the electrostatic holding device comprises at least one heater, preferably in form of a heating plate, wherein the at least one heater is arranged at the support layer, preferably at the side of the support layer facing away from the electrode layer.

In a preferred embodiment the heater is formed by the electrode layer, i.e. the electrode layer then has two functions: being charged in order to induce an electrostatic force and heating the (preferably flat) object when received by the receiving surface. In this case the electrode layer is connected with a preferably controllable current source such that a heating current may be lead through the electrode layer (preferably from one side to the opposing side of the electrode layer). Moreover, the electrode layer is connectable to an electrical potential or voltage source for charging the electrical layer, namely its electrically conductive component.

An (thermal) insulating layer for thermally decoupling the support layer from the first electrically insulating layer may be provided when the electrode layer is also the heater. In that way energy is more readily transferred to the object gripped with the holding device.

In a preferred embodiment the first electrically insulating layer, which is arranged between the electrode layer and the support layer, and/or the second electrically insulating layer extend(s) in lateral directions beyond the electrode layer, preferably by at least 0,2cm, preferably by at least 0,5cm. By this measure the risk of disruptive discharge in the lateral area of the electrode layer, i.e. from the electrically conductive component of the electrode layer towards the support layer, which is usually made of metal, or towards the object, when arranged at the receiving surface, is significantly reduced.

In a preferred embodiment the receiving surface is formed at least partially by the surface of the second electrically insulating layer. The distance between the electrically conductive component and the receiving surface is held small, particularly if the second electrically insulating layer has a thickness smaller than 200µm, preferably smaller than 100µm.

In a preferred embodiment the receiving surface is formed at least partially by at least one electrical conductor, preferably at least one conducting strip, for grounding the object and/or for applying a potential to the object. According to this embodiment electrical conductors are provided in order to come into contact with the object. The arrangement of the conductors may be such that the object or (a) partial area(s) of the object are brought to a defined electrical potential, e.g. ground potential, and/or to induce an electrical current through the flat object.

In a preferred embodiment the receiving surface is formed at least partially by at least two electrical conductors, preferably at least two conducting strips, wherein at least one of the electrical conductors is connected to a first potential, preferably to ground potential, and at least one other electrical conductor is connected to a second potential which is different from the first potential.

Preferably, the at least one conductor, preferably all conductors, are mounted on, preferably glued to, the surface of the second electrically insulating layer. It is preferred, if they form a spacer for distancing the (flat) object at least partially from the surface of the second electrically insulating layer.

In their function of a spacer the conductor(s) efficiently prevent the generation of vacuum or under-pressure between the object and the receiving surface when the object is moved away from the receiving surface. Additionally or alternatively, further distancing elements may be provided.

The conductors may be formed by copper strips. It is preferred if the at least one conductor is mounted to the second electrical insulating layer by a preferably two-sides (self-) adhesive film or strip, preferably by a Kapton (-strip).

In a preferred embodiment the electrode layer has a lateral extension, preferably in form of a strip or a protrusion, which extends outside the area enclosed by the first electrically insulating layer and the second electrically insulating layer. This enables the electrical contacting of the electrode layer in an elegant and simple way.

In a preferred embodiment the support layer has a depression and/or a housing in which the lateral extension of the electrode layer is accommodated and/or electrically connected, preferably by means of a crimp connection, with an electrical conductor (preferably a cable) and/or surrounded by an electrically insulating material, preferably silicone. The connection then is protected and characterized by a space-saving design.

In a preferred embodiment the layers of the layered structure are connected with each other by means of an adhesive.

The object is also achieved with a joining device for joining at least one object, preferably a flat object, with another object, preferably a flat object, such as a solar cell with a foil, preferably a wire foil, comprising a joining area and a transport device according for transporting objects to the joining area, wherein the transport device comprises at least one electrostatic holding device according to the invention. In joining devices it is of great importance to transport flat or wafer-shaped objects particularly solar cells without imparting damages to it. The use of an electrostatic holding device in such a joining device guarantees reliable gripping and holding of the flat objects (during transport) and an essentially constant holding force over the holding surface.

The object is also achieved by a method of transporting flat objects with a transport device, preferably in a joining device, wherein the transport device comprises at least one electrostatic holding device according to the invention, the method comprising the steps of
- gripping a object, preferably a flat object, such as a wafer, a solar cell and/or a foil, by activating the electrostatic holding device, and
- moving the electrostatic holding device while holding the object,
- depositing the object by releasing the object from the electrostatic holding device.

The object is also achieved by the use of an electrostatic holding device according to the invention in gripping and/or holding and/or transporting an object, preferably a flat object, such as a wafer, a solar cell and/or a foil, preferably in a joining device according to the invention.

Further embodiments of the invention are indicated in the figures and in the dependent claims. The list of reference marks forms part of the disclosure. The invention will now be explained in detail by the drawings. In the drawings:
- Fig. 1: shows in a cross-section an electrostatic holding device according to the invention,
- Fig. 2: shows an embodiment of the electrode layer built up of an electrically insulating film substrate, which is coated by an electrically conductive component,
- Fig. 3: shows an embodiment of the electrode layer with the electrically conductive component being dispersed within a dielectric component,
- Fig. 4: shows in a top view a preferred embodiment of the electrostatic holding device,
- Fig. 5: shows the electrode layer connected to a current source and to an electrical charging potential.

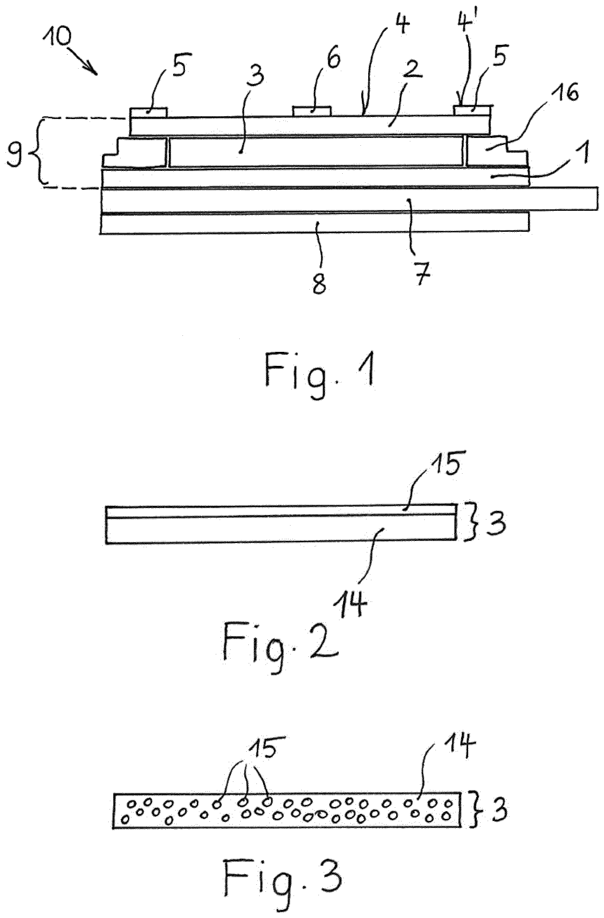

Fig. 1 shows an electrostatic holding device 10 for electrostatically holding an object (not shown), preferably a flat object, particularly a wafer, a solar cell and/or a foil. The electrostatic holding device 10 comprises a receiving surface 4, 4' for receiving an object, a support layer 7 and - between the support layer 7 and the receiving surface 4 - a layered structure 9.

The layered structure comprises, in the following order from the support layer 7 to the receiving surface 4: a first electrically insulating layer 1 made of a dielectric film, an electrode layer 3 and a second electrically insulating layer 2 made of a dielectric film.

The layers 1, 3, 2 of the layered structure 9 may be connected with each other by means of an adhesive. A lateral or surrounding layer 16 which laterally surrounds the electrode layer 3 may be provided as well.

The electrode layer 3 is arranged between the first electrically insulating layer 1 and the second electrically insulating layer 2. As can be seen from the Figs. 1 to 3 the electrode layer 3 is formed by a film which is built up from a dielectric component 14 and an electrically conductive component 15.

In the embodiment of Fig. 2 the film forming the electrode layer 3 has two sublayers joined with each other. One of the sublayers is formed by the dielectric component 14 and the other sublayer is formed by the electrically conductive component 15. It is preferred if the dielectric component 14 is an electrically insulating film substrate, which is coated by the electrically conductive component 15.

In the embodiment of Fig. 3 the electrically conductive component 15 is dispersed - in form of particles, preferably metallic particles - within the dielectric component 14.

The dielectric film of the first and second electrically insulating layers 1, 2 may be polyimide films, preferably Kapton.

Also, the dielectric component 14 of the film forming the electrode layer 3 may be made of polyimide, preferably Kapton.

In order to achieve the same or similar thermal expansion behavior the dielectric component 14 of the film forming the electrode layer 3 may be made of the same material as the dielectric film of the first electrically insulating layer 1 and/or the dielectric film of the second electrically insulating layer 2.

The support layer 7 supports the layered structure 9 and may be formed by a metal plate, preferably an aluminum plate.

In the embodiment of Fig. 1 the electrostatic holding device 10 comprises at least one heater 8, preferably in form of a heating plate. The heater 8 of Fig. 1 is arranged at the support layer 7, here at the side of the support layer 7 facing away from the electrode layer 3.

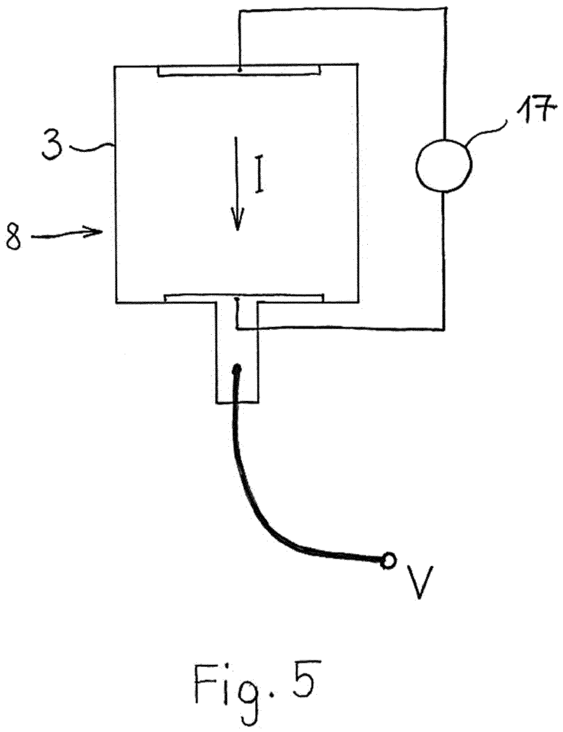

In the embodiment of Fig. 5 the heater is not a separate element but the heater 8 is formed by the electrode layer 3. I.e. the electrode layer 3 then has two functions:
(1) as an electrode for being charged - by means of an electrical potential or voltage source V - in order to induce an electrostatic force (acting on the object) and
(2) as a heater for heating the object when received by the receiving surface. In this case the electrode layer is connected with a preferably controllable current source 17 such that a heating current I may be lead through the electrode layer 3 (preferably from one side to the opposing side of the electrode layer).

As can be seen from Fig. 1 the first electrically insulating layer 1 which is arranged between the electrode layer 3 and the support layer 7 extends in lateral directions beyond the electrode layer 3, preferably by at least 0,2cm, preferably by at least 0,5cm. With such a measure disruptive discharge in the lateral areas may be prevented.

The receiving surface 4, 4' is formed at least partially by the surface of the second electrically insulating layer 2.

The receiving surface 4, 4' is formed at least partially by at least one electrical conductor 5, 6, preferably at least one conducting strip, for grounding the object and/or for applying a potential to the object.

In Fig. 1 the receiving surface 4 is formed at least partially by three electrical conductors (5, 6), in form of conducting strips. At least one of the electrical conductors 5 may be connected to a first potential, preferably to ground potential, and at least one other electrical conductor 6 may be connected to a second potential which is different from the first potential.

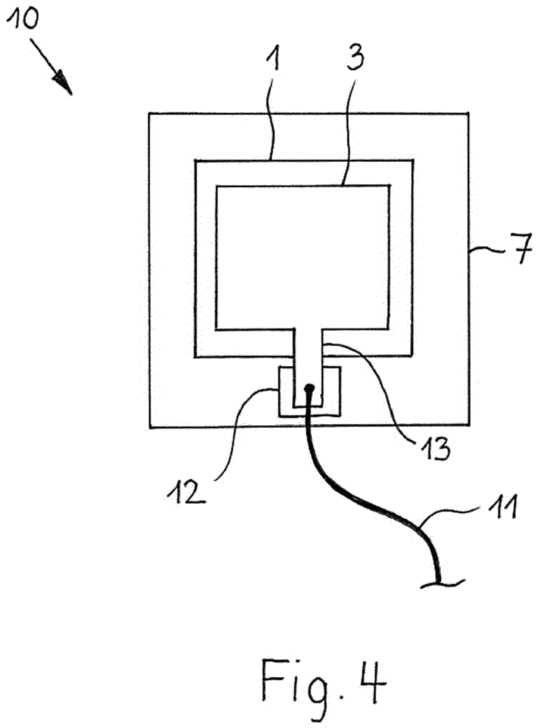

As can be seen from Fig. 4 the electrode layer 3 may have a lateral extension 13, here in form of a strip or a protrusion, which extends outside the area enclosed by the first electrically insulating layer 1 and the second electrically insulating layer 2 (and lateral layer(s) 16). The support layer 7 may have a depression 12 or a housing in which the lateral extension 13 of the electrode layer 3 is accommodated and/or electrically connected with an electrical conductor 11 and/or surrounded by an electrically insulating material, preferably silicone. The electrical connection (with a cable) may be done by means of a crimp connection.

The invention is not restricted to these embodiments. Other variants will be obvious for the person skilled in the art and are considered to lie within the scope of the invention as formulated in the following claims. Individual features described in all parts of the above specification, particularly with respect to the figures may be combined with each other to form other embodiments and/or applied mutatis mutandis to what is described in the claims and to the rest of the description, even if the features are described in respect to or in combination with other features.

### List of reference signs

- 1: first electrically insulating layer
- 2: second electrically insulating layer
- 3: electrode layer
- 4, 4': receiving surface
- 5: electrical conductor
- 6: electrical conductor
- 7: support layer
- 8: heater
- 9: layered structure
- 10: electrostatic holding device
- 11: electrical conductor
- 12: depression
- 13: lateral extension
- 14: dielectric component
- 15: electrically conductive component
- 16: lateral or surrounding layer
- 17: current source
- I: heating current
- V: electrical potential or voltage source

## Claims

1. Electrostatic holding device (10) for electrostatically holding an object, preferably a flat object, such as a wafer, a solar cell and/or a foil, comprising
- a receiving surface (4, 4') for receiving the object, wherein preferably the receiving surface (4, 4') is flat, and
- a support layer (7),
wherein the electrostatic holding device (10) has between the support layer (7) and the receiving surface (4, 4') a layered structure (9) comprising, preferably in this order from the support layer (7) to the receiving surface (4):
- a first electrically insulating layer (1) made of a dielectric film,
- an electrode layer (3) and
- a second electrically insulating layer (2) made of a dielectric film,
wherein the electrode layer (3) is arranged between the first electrically insulating layer (1) and the second electrically insulating layer (2), **characterized in that** the electrode layer (3) is formed by a film which is built up from a dielectric component (14) and an electrically conductive component (15).

2. Electrostatic holding device according to claim 1, wherein the film forming the electrode layer (3) has two sublayers joined with each other, wherein one of the sublayers is formed by the dielectric component (14) and the other sublayer is formed by the electrically conductive component (15), and/or wherein the dielectric component (14) is an electrically insulating film substrate, which is coated by the electrically conductive component (15).

3. Electrostatic holding device according to claim 1, wherein the electrically conductive component (15) is dispersed within the dielectric component (14).

4. Electrostatic holding device according to one of the preceding claims, wherein the dielectric film of the first electrically insulating layer (1) and the dielectric film of the second electrically insulating layer (2) are polyimide films, preferably Kapton.

5. Electrostatic holding device according to one of the preceding claims, wherein the dielectric component (14) of the film forming the electrode layer (3) is made of polyimide, preferably Kapton.

6. Electrostatic holding device according to one of the preceding claims, wherein the dielectric component (14) of the film forming the electrode layer (3) is made of the same material as the dielectric film of the first electrically insulating layer (1) and/or the dielectric film of the second electrically insulating layer (2).

7. Electrostatic holding device according to one of the preceding claims, wherein the support layer (7) is formed by a metal plate, preferably an aluminum plate.

8. Electrostatic holding device according to one of the preceding claims, wherein the electrostatic holding device (10) comprises at least one heater (8), preferably in form of a heating plate, wherein the at least one heater (8) is arranged at the support layer (7), preferably at the side of the support layer (7) facing away from the electrode layer (3), or wherein the heater is formed by the electrode layer (3).

9. Electrostatic holding device according to one of the preceding claims, wherein the first electrically insulating layer (1) which is arranged between the electrode layer (3) and the support layer (7) extends in lateral directions beyond the electrode layer (3), preferably by at least 0,2cm, preferably by at least 0,5cm.

10. Electrostatic holding device according to one of the preceding claims, wherein the receiving surface (4, 4') is formed at least partially by the surface of the second electrically insulating layer (2).

11. Electrostatic holding device according to one of the preceding claims, wherein the receiving surface (4, 4') is formed at least partially by at least one electrical conductor (5, 6), preferably at least one conducting strip, for grounding the object and/or for applying a potential to the object.

12. Electrostatic holding device according to one of the preceding claims, wherein the receiving surface (4, 4') is formed at least partially by at least two electrical conductors (5, 6), preferably at least two conducting strips, wherein at least one of the electrical conductors (5) is connected to a first potential, preferably to ground potential, and at least one other electrical conductor (6) is connected to a second potential which is different from the first potential.

13. Electrostatic holding device according to one of the preceding claims, wherein the electrode layer (3) has a lateral extension (13), preferably in form of a strip or a protrusion, which extends outside the area enclosed by the first electrically insulating layer (1) and the second electrically insulating layer (2).

14. Electrostatic holding device according to claim 13, wherein the support layer (7) has a depression (12) and/or a housing in which the lateral extension (13) of the electrode layer (3) is accommodated and/or electrically connected, preferably by means of a crimp connection, with an electrical conductor (11), preferably a cable, and/or surrounded by an electrically insulating material, preferably silicone.

15. Electrostatic holding device according to one of the preceding claims, wherein the layers (1, 3, 2) of the layered structure (9) are connected with each other by means of an adhesive.
